## Europäisches Patentamt
## European Patent Office
## Office européen des brevets

(19)

(11) Veröffentlichungsnummer: **0 025 130**
**B1**

(12)

# EUROPÄISCHE PATENTSCHRIFT

(45) Veröffentlichungstag der Patentschrift:
16.07.86

(51) Int. Cl.⁴: **G 11 C 17/00, H 01 L 27/10**

(21) Anmeldenummer: **80104762.2**

(22) Anmeldetag: **12.08.80**

(54) **Hochintegrierter Festwertspeicher.**

(30) Priorität: **11.09.79 US 74272**

(43) Veröffentlichungstag der Anmeldung:
**18.03.81 Patentblatt 81/11**

(45) Bekanntmachung des Hinweises auf die Patenterteilung:
**16.07.86 Patentblatt 86/29**

(84) Benannte Vertragsstaaten:
**DE FR GB IT NL SE**

(56) Entgegenhaltungen:
**DE - A - 2 852 049**

**IBM TECHNICAL DISCLOSURE BULLETIN, Band 10, Nr. 1, Juni 1967, Seiten 77-78, USA., R.H. DENNARD et al.: "Mosfet array for a read-only store"**
**PATENTS ABSTRACTS OF JAPAN, Band 2, Nr. 94, 5. August 1978, Seite 4371E78**
**IBM TECHNICAL DISCLOSURE BULLETIN, Band 22, Nr. 8B, Januar 1980, Seiten 3636-3637, USA., S.G. CHAKRAVARTI et al.: "Zigzag word lines ros array"**

(73) Patentinhaber: **International Business Machines Corporation, Old Orchard Road, Armonk, N.Y. 10504 (US)**

(72) Erfinder: **Chakravarti, Satya Narayan, 44 Brinsmade Terrace, Troy New York 12181 (US)**
Erfinder: **Hiltebeitel, John Andrew, 8 Yandow Drive, SO. Burlington Vermont 05401 (US)**

(74) Vertreter: **Rudolph, Wolfgang, Dipl.-Ing., Schönaicher Strasse 220, D-7030 Böblingen (DE)**

**Beschreibung**

Die Erfindung betrifft einen hochintegrierten Festwertspeicher nach dem Oberbegriff des Patentanspruchs 1.

Hochintegrierte Festwertspeicher, insbesondere mit Feldeffekttransistoren, in denen jeder Transistor bzw. jede Zelle eine 1 oder eine 0 repräsentiert und die eine sehr hohe Zelldichte aufweisen, sind an sich bekannt. So ist z.B. aus der US-PS 3 914 855 ein Festwertspeicher bekannt, der mit verschieden dickem Dielektrikum an den Gate-Elektroden ausgerüstet ist. Die resultierenden verschieden hohen Schwellwertspannungen an den Gate-Elektroden dienen dann zur Darstellung der zwei zu speichernden binären Werte 1 und 0.

Der Festwertspeicher nach diesem genannten US-Patent wird hergestellt, indem die Personalisierung der einzelnen Speicherzellen schon sehr frühzeitig während des Herstellungsprozesses durch Ätzen und Ionenimplantation vorgenommen wird, wodurch sich relativ breite Gate-Elektroden und Wortleitungen ergeben, die die Speicherdichte und damit eine noch höhere gewünschte Integration begrenzen.

Ausserdem ist aus der US-PS 4 059 826 ein Festwertspeicher bekannt geworden, der während der Herstellung durch Ionenimplantation personalisiert wird. Durch den Ionenimplantationsprozessschritt wird während des Herstellungsverfahrens erreicht, dass die Schwellspannung auf ungefähr Null festgesetzt wird, wodurch diese Transistoren permanent eingeschaltet sind. Die anderen Transistoren, die nicht diesem Ionenimplantationsschritt unterworfen worden sind, haben eine höhere Schwellwertspannung und stellen damit den zweiten binären Wert dar. Die Personalisierung bei diesem Speicher erfolgt also auch vor der eigentlichen Formierung der Gate-Elektroden des Transistors, weshalb auch hier relativ breite Gate-Elektroden und Wortleitungen erzielt werden, die eine höhere Integration nicht zulassen.

Ein weiterer Festwertspeicher ist in der US-PS 4 096 522 beschrieben, der in einer relativ späten Stufe des Herstellungsprozesses personalisiert wird. Dieser Speicher hat jedoch den Nachteil, dass nahe der Gate-Elektrode eine Lücke für die Ionenimplantation gelassen werden muss, die die weitere Integration so stark beeinträchtigt, dass sich auch ein derartig aufgebauter Festwertspeicher nicht für eine weitere Zellenintegration eignet.

In der US-PS 4 161 039 ist ein Halbleiterspeicher mit Feldeffekttransistoren bekannt geworden, die gleitende Gates aufweisen. Die Kanalregion ist hier kurz ausgeführt und zwar durch Anwendung der Doppeldiffusionstechnik, wie sie in «Electronics», Februar 1971, Seiten 99 bis 104 beschrieben ist. Dieser Speicher hat jedoch den Nachteil, dass der Aufbau äusserst kompliziert ist und auch nur durch Löschen von gespeicherten Informationen mit ultraviolettem Licht personalisiert werden kann.

Ausserdem ist aus dem Artikel "Here Come the Big, New 64-K ROMs," in Electronics, März 1978, Seiten 94 bis 97 ein Festwertspeicher bekannt, der nur die eine Hälfte des Kontakts benötigt, weil jede Zelle mit einer anderen Zelle den Kontakt teilt.

Des weiteren ist es von Ferritkernspeichern her bekannt, wie z.B. aus US-PS 3 056 113, ausser den vertikal bzw. horizontal verlaufenden Bit- und Wortleitungen noch schräg verlaufende oder im Zickzack verlaufende Leitungen zur Steuerung und Unterdrückung zu verwenden. Bei hochintegrierten Halbleiterspeichern hat man eine derartige Leitungsführung bisher wegen der grossen Komplikationen mit darunterliegenden Bauelementen und Leitungen abgelehnt.

Der Erfindung liegt nun die Aufgabe zugrunde, einen Festwertspeicher in höchst integrierter Bauweise zu schaffen, der bei Verwendung nur eines Transistors für eine Speicherzelle eine sehr hohe Leistungsfähigkeit, d.h. eine äusserst kurze Zugriffszeit aufweist und bei dem Elemente, wie z.B. Kontakte, durch mehrere im Festwertspeicher vorhandene Transistoren gemeinsam benutzt werden.

Die erfindungsgemässe Lösung dieser Aufgabe besteht im Kennzeichen des Patentanspruchs 1.

Weitere wesentliche Erfindungsmerkmale sind in den Kennzeichen der Patentansprüche 2 bis 5 charakterisiert.

Der besondere Vorteil eines derart aufgebauten Festwertspeichers in höchst integrierter Technik besteht darin, dass die Wortleitungen, die Bitleitungen und die Leitungen für ein Referenzpotential sowie die Diffusionsregionen, die die Source- und Drainbereiche der Feldeffekttransistoren bilden, mit jeder Diffusions-Region vier Transistoren oder Zellen versorgen. Dieses ist bisher nicht erreicht worden, so dass die Integrationsdichte eines derart aufgebauten Speichers wesentlich höher liegt als die der bisher bekannten Speicher des vorher angegebenen Typs.

Die Erfindung wird nun anhand von in den Zeichnungen dargestellten Ausführungsbeispielen näher beschrieben.

Es zeigen:

Fig. 1, einen Festwertspeicher, der matrixförmig angeordnete Feldeffekttransistoren aufweist,

Fig. 2, ein Impulsdiagramm für den Speicher nach Fig. 1,

Fig. 3, eine Draufsicht auf eine Ausführung des Speichers nach Fig. 1,

Fig. 4, einen Querschnitt durch den Speicher nach Fig. 3 entlang der Linie 4–4,

Fig. 5, einen weiteren Schnitt des Speichers nach Fig. 3 entlang der Linie 5–5 und

Fig. 6, eine weitere Schnittansicht durch den Speicher nach Fig. 3 entlang der Linie 6–6.

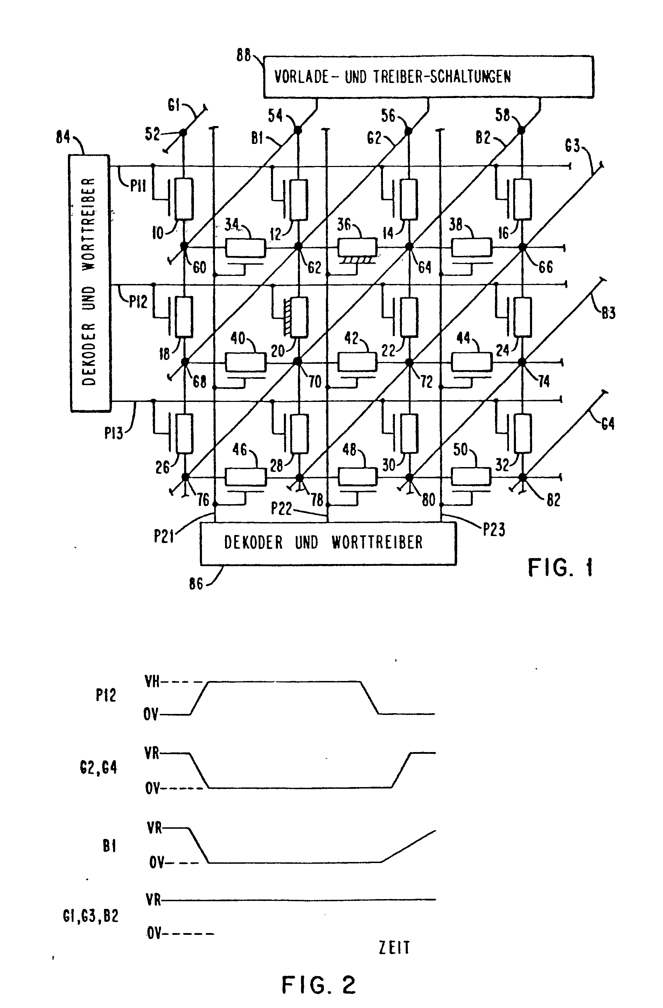

Der in Fig. 1 dargestellte Festwertspeicher besteht aus einer ersten horizontalen Wortleitung P11, die mit den Gate-Elektroden der Feldeffekttransistoren 10, 12, 14 und 16 verbunden ist, einer zweiten horizontalen Wortleitung P12, die mit den Gate-Elektroden der Feldeffekttransistoren 18, 20, 22 und 24 verbunden ist und einer dritten horizontalen Wortleitung P13, die mit den Gate-Elektroden der Feldeffekttransistoren 26, 28, 30 und 32 verbunden ist. Ausserdem ist eine erste vertikale Wortleitung P21 vorhanden, die mit den Gate-Elektroden der Transistoren 34, 40 und 46 verbunden ist, und eine zweite Wortleitung P22, die mit den Gate-Elektroden der Transistoren 36, 42 und 48 verbunden ist, und ausserdem ist eine dritte vertikale Wortleitung P23 vorhanden, die mit den Gate-Elektroden der Transistoren 38, 44 und 50 verbunden ist.

Die Source-Elektroden-Kontakte für die Transistoren 10 und 14 sind mit 52 bzw. 56 bezeichnet, die Drain-Elektroden-Kontakte für die Transistoren 12 und 16 sind mit 54 bzw. 58 gekennzeichnet. Ein gemeinsamer Drain-Elektroden-Kontakt für die Transistoren 10, 18 und 34 ist mit 60 bezeichnet und ein gemeinsamer Drain-Kontakt für die Transistoren 14, 22, 36 und 38 ist mit 64 bezeichnet. Ausserdem ist ein gemeinsamer Source-Elektroden-Kontakt 62 für die Transistoren 12, 20, 34 und 36 sowie ein gemeinsamer Source-Kontakt 66 vorhanden, und zwar für die Transistoren 16, 24 und 38.

Die Transistoren 18, 26 und 14, 40 haben ausserdem einen gemeinsamen Source-Elektroden-Kontakt 68, und die Transistoren 22, 30, 42 und 44 haben einen gemeinsamen Source-Elektroden-Kontakt 72.

Die Transistoren 20, 28, 40 und 42 haben einen gemeinsamen Drain-Elektroden-Kontakt 70 und die Transistoren 24, 32 und 44 haben einen gemeinsamen Drain-Elektroden-Kontakt 74. Der gemeinsame Drain-Elektroden-Kontakt 76 ist für die Transistoren 26 und 46 vorgesehen und der gemeinsame Drain-Elektroden-Kontakt 80 gehört zu den Transistoren 30, 48 und 50. Der gemeinsame Source-Elektroden-Kontakt 78 versorgt die Transistoren 28, 46 und 48, und der gemeinsame Source-Elektroden-Kontakt 82 versorgt die Transistoren 32 und 50. Eine Masseleitung ist mit dem Source-Elektroden-Kontakt 52 verbunden, eine Masseleitung G2 ist mit den Source-Elektroden-Kontakten 56, 62 und 68 verbunden, eine Masseleitung G3 ist mit den Source-Elektroden-Kontakten 66, 72 und 78 verbunden, und eine vierte Masseleitung G4 ist mit dem Source-Elektroden-Kontakt 82 verbunden. Eine Bitleitung B1 ist mit den Drain-Elektroden-Kontakten 54 und 60 verbunden, eine Bitleitung B2 mit den Drain-Elektroden-Kontakten 58, 64, 70 und 76 und eine Bitleitung B3 mit den Drain-Elektroden-Kontakten 74 und 80.

Die horizontalen Wortleitungen P11 bis P13 sind mit den Decodern und Worttreibern 84 verbunden, während die vertikalen Wortleitungen P21 bis P23 mit den Decodern und Worttreibern 86 verbunden sind. Die Decoder und Worttreiber 84 und 86 sind schaltungsmässig nicht ausgeführt, da diese Schaltungen hinlänglich bekannt sind. Die Masseleitungen G1 bis G4 und die Bitleitungen B1 bis B3 sind mit ebenfalls hinlänglich bekannten Vorladeschaltkreisen und Abfühl-/Leseverstärkern 88 verbunden, die ebenfalls nicht näher beschrieben werden.

Die ungeradzahlig bezeichneten Masseleitungen G1, G3, ... sind miteinander verbunden genauso wie die geradzahlig bezeichneten Masseleitungen G2, G4, ... Ausserdem können eine Anzahl von Bitleitungen miteinander zu Gruppen verbunden sein, wobei jede eine gleiche Anzahl von Bits aufweist, aber in solch einer Art und Weise, dass keine einzelne Wortleitung mehr als einen Transistor selektiert, der dieselbe Bitleitung und Masseleitung mitbenutzt.

Es soll hier erwähnt sein, dass alle in Fig. 1 dargestellten Transistoren eine bestimmte Schwellwertspannung aufweisen, mit Ausnahme der Transistoren 20 und 36, die eine Schwellwertspannung aufweisen, die davon verschieden ist und zwar insbesondere höher liegt. Die Transistoren 20 und 36 sind durch Schrägstriche an den Gate-Elektroden besonders hervorgehoben. Obwohl in der Fig. 1 nur zwei derartige Transistoren mit höherer Schwellwertspannung gezeigt sind, ist es selbstverständlich möglich, dass Festwertspeicher mit jeder anderen gewünschten Anzahl von Transistoren mit höherer Schwellwertspannung aufgebaut werden können.

In Fig. 2 ist ein Impulsdiagramm dargestellt, das zum Betrieb des Festwertspeichers nach Fig. 1 erforderlich ist. Anhand dieses Diagramms wird die Wirkungsweise des Festwertspeichers nach Fig. 1 nachfolgend erklärt.

Um zum Beispiel eine Information aus dem Festwertspeicher nach Fig. 1 von den Zellen zu lesen, die der Wortleitung P12 zugeordnet sind, wird das Potential auf allen Wortleitungen auf 0 Volt abgesenkt und die Bitleitungen B1 bis B3 sowie die Masseleitungen G1 bis G4 werden alle auf das Potential VR aufgeladen, welches kleiner oder gleich dem Potential VH ist, das z.B. bei $+5$ Volt liegen könnte. Nachdem die Bitleitungen und die Masseleitungen aufgeladen worden sind, steigt die Spannung auf der Wortleitung P12 auf das Potential VH und die Spannung auf der Masseleitung G2 wird auf das Nullpotential abgesenkt, wie es aus dem Diagramm in Fig. 2 zu ersehen ist. Da der Transistor 18 eine relativ niedrige Schwellwertspannung besitzt, schaltet er ein und die Bitleitung B1 wird über den Transistor 18 zum Source-Elektroden-Kontakt 68 hin entladen, da dieser sich auf Massepotential befindet wie in Fig. 2 dargestellt. Da der Transistor 20 anderseits eine relativ hohe Schwellwertspannung hat, wird er nicht eingeschaltet, wodurch die Spannung auf der Bitleitung B2 hoch bleibt. Damit ist z.B. eine binäre Null im Transistor 18 und eine binäre Eins im Transistor 20 gespeichert, die vom über die Bitleitungen B1 und B2 angeschlossenen Abfühl-/Leseverstärker 88 abgefühlt und erkannt werden können. Die Masseleitung G3 wird auf ihrem hohen Potential VR gehalten, währenddessen die gespeicherte Information aus den Transistoren 18 und 19 gelesen wird, so dass die Bitleitung B2 nicht über den Transistor 22 entladen wird. Ebenfalls wird die Spannung auf der Masseleitung G1 hochgehalten, wenn über die Bitleitungen B1 und B2 ausgelesen wird, um Auslesefehler zu vermeiden. Dadurch kann erreicht werden, dass eine Hälfte der Zellen, die mit der Wortleitung P12 verbunden sind, während einer ersten Zeitspanne ausgelesen werden, während die restlichen mit der Wortleitung P12 verbundenen Transistoren durch entsprechende Selektion auf den Bit- und Masseleitungen zu einem anderen Zeitabschnitt ausgelesen werden. Es soll hier ausserdem angemerkt sein, dass die Transistoren oder Zellen, die mit den vertikalen Wortleitungen P21 bis P23 verbunden sind, in ähnlicher Weise selektiert und ausgelesen werden können.

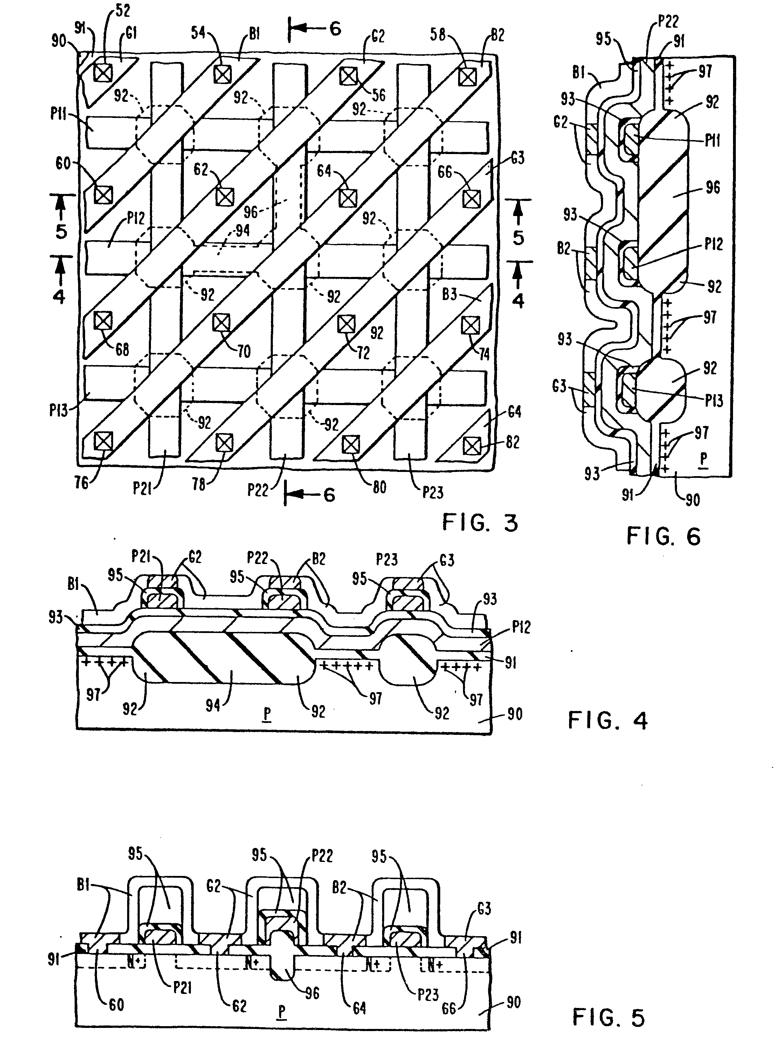

In den Fig. 3 bis 6 ist eine detaillierte Struktur des in Fig. 1 dargestellten Festwertspeichers angegeben. Der Festwertspeicher besteht aus einem Substrat 90, das P-leitend ist und in dem dicke Isolations-Oxidsegmente 92 und dicke Oxidstreifen 94 und 96 zur Schaffung einer hohen Schwellwertspannung der Transistoren, wie z.B. der Transistoren 20 und 36 in Fig. 1, ein- oder aufgebracht sind.

Diese Segmente und Streifen werden vorzugsweise aus Siliciumdioxid hergestellt. Eine dünne Oxidschicht 91, die z.B. ebenfalls aus Siliciumdioxid hergestellt werden kann, wird auf Oberflächenbereiche des Substrats 90 ausserhalb der dicken Oxidsegmente und -streifen aufgebracht. Die dünnen Oxidstreifen 91 können dabei eine Dicke von ungefähr 500 Å aufweisen. Über die dünne Oxidschicht 91 und die dicken Oxidsegmente und -streifen 92, 94 und 96 wird eine erste gedopte Polysiliciumschicht aufgebracht, die dann in bekannter Art und Weise geätzt werden kann, um die Wortleitungen P11, P12 und P13 zu formen. Der Teil der dünnen Oxidschicht 91, der nicht durch die horizontalen Wortleitungen P11 bis P13 abgedeckt ist, wird entfernt und eine neue Schicht eines dünnen Oxids 91 mit einer Dicke, die gleich der Dicke der dünnen Oxidschicht ist, die durch die horizontalen Wortleitungen P11 bis P13 abgedeckt ist, wird aufgebracht, wodurch die Gate-Oxidschicht für die vertikalen Polysiliciumwortleitungen P21 bis P23 geschaffen wird. Danach wird eine zweite Schicht von gedoptem Polysilicium auf die Oberfläche aufgebracht und die vertikalen Wortleitungen P21 bis P23 werden von der zweiten Polysiliciumschicht geätzt, so dass die horizontalen Wortleitungen P11 bis P13 von der ersten Polysiliciumschicht und die vertikalen Wortleitungen P21 bis P23 von der zweiten Polysiliciumschicht gebildet werden und sich über den dicken Oxidsegmenten 92 kreuzen. Die Wortleitungen haben eine Breite von ungefähr 3,6 μ. Eine weitere Isolationsschicht 95, die vorzugsweise durch Selbstoxidation der vertikalen Polysilicium-Wortleitungen P21 bis P23 erzeugt wird, umschliesst die vertikalen Polysilicium-Wortleitungen P21 bis P23, wie aus Fig. 4 und aus Fig. 6 zu ersehen ist. Es wird angemerkt, dass mit gleicher Dicke der dünnen Gate-Oxidschicht sowohl unter den horizontalen als auch unter den vertikalen Wortleitungen alle damit verbundenen Transistoren dieselbe Schwellwertspannung aufweisen.

Um die Source- und Drain-Elektroden zu bilden, die durch die horizontalen und vertikalen Polysilicium-Wortleitungen P11 bis P13 und P21 bis P23 definiert sind, wird Arsen in die Oberfläche des Substrats 90 implantiert. Diese Diffusionsregionen sind als N+-Regionen in Fig. 5 markiert. Nach

dem Implantationsprozessschritt wird eine Metallschicht, z.B. Aluminium, über dieser Struktur aufgebracht und geätzt, um die schräg oder diagonal verlaufenden Bit- und Masseleitungen B1 bis B3 und G1 bis G4 zu bilden. Vor dem Aufbringen der Metallschicht werden auf bekannte Art und Weise die erforderlichen Öffnungen in die dünne Oxidschicht 91 gebracht, um die Source- und Drain-Elektroden-Kontakte, z.B. angegeben bei 60, 62, 64 und 66, zu definieren, die mit den Source- und Drain-Elektroden-N+-Diffusionen (siehe Fig. 5) verbunden sind. Ausserdem sollten, wie bekannt, vor der Bildung der ersten gedopten Polysiliciumschicht Boronionen 97, wie in den Fig. 4 und 6 dargestellt, in die Oberfläche des Substrats 90 implantiert werden.

Der so gebildete Festwertspeicher kann durch die Implantation von Boronionen in die Kanalregionen der Transistoren personalisiert werden. Ausserdem kann die Personalisierung des Festwertspeichers auch durch Schaffung gleitender Gate-Elektroden oder durch Transistoren bzw. Zellen mit variabler Schwellwertspannung hergestellt werden. Durch Änderung der Schwellwertspannung der selektierten Zellen ist es durch die vorliegende Erfindung auch möglich, einen löchbaren, programmierbaren Festwertspeicher zu schaffen. Aus den Ausführungsbeispielen der Fig. 3 bis 6 geht ganz klar hervor, dass der wesentliche Anteil der Siliciumfläche tatsächlich nur für Gate-Elektroden, für Source-Elektroden und -diffusionen der die Speicherzellen bildenden Transistoren verwendet wird. Der einzige Teil der Oberfläche des Substrats 90, der nicht als Teil einer Transistorzelle verwendet wird, ist dort, wo die dicken Oxidsegmente 92 in der Kreuzung der horizontalen und vertikalen Polysilicium-Wortleitungen liegen. Es soll noch erwähnt sein, dass jeder der Source- und Drain-Elektroden-Kontakte dazu verwendet wird, bis zu vier Transistoren oder Zellen eines Festwertspeichers mit dem erforderlichen Strom zu versorgen oder mit der entsprechenden Spannung zu verbinden. Durch diese Massnahme und die diagonal verlaufenden Leitungen wird eine Speicherzellendichte erreicht, die in Zukunft von höchst integrierten Festwertspeichern gefordert wird. Obwohl das Ausführungsbeispiel aufbauend auf einem P-leitenden Substrat beschrieben ist, ist es selbstverständlich auch ohne weiteres möglich, ein N-leitendes Substrat zu verwenden und dann bekannterweise die Leitfähigkeit der anderen Regionen entsprechend umzukehren.

**Patentansprüche**

1. Festwertspeicher in hochintegrierter Technik mit in Kreuzungspunkten von Wort- und Bitleitungen matrixförmig angeordneten Speicherzellen, die aus einem Feldeffekttransistor mit Gate-, Drain- und Sourceelektroden bestehen, dadurch gekennzeichnet, dass eine erste Gruppe von Wortleitungen (P11 bis P13) horizontal und eine zweite Gruppe von Wortleitungen (P21 bis P23) vertikal verläuft, dass die Bitleitungen (B1, B2) und Leitungen (G1 bis G4) für ein Referenzpotential diagonal zu den Wortleitungen angeordnet sind, dass die Wortleitungen mit den Gateelektroden verbunden sind, dass die Bitleitungen mit den Drainelektroden und die Leitungen für das Referenzpotential mit den Sourceelektroden über Kontakte (64, 62) verbunden sind und dass jeder nicht am Rand der Matrix liegende Kontakt (z.B. 70) der Bitleitungen sowie jeder nicht am Rand der Matrix liegende Kontakt (z.B. 62) der Leitungen für das Referenzpotential mit vier Zellen über eine unter dem Kontakt angeordnete vier Source- bzw. vier Drainelektroden bildende Diffusionsregion (N+) verbunden ist.

2. Festwertspeicher nach Anspruch 1, dadurch gekennzeichnet, dass eine bestimmte Anzahl von Feldeffekttransistoren (36, 20) innerhalb einer matrixförmigen Anordnung unterschiedliche Schwellwertspannungen aufweisen.

3. Festwertspeicher nach den Ansprüchen 1 und 2, dadurch gekennzeichnet, dass die erste Gruppe von Wortleitungen (P11–P13) auf dem Substrat (90) isoliert angeordnet ist, dass die Bitleitungen (B1, B2) und weitere Leitungen (z.B. G2) ebenfalls isoliert auf dem Substrat (90) und die erste Gruppe von Wortleitungen kreuzend angeordnet sind, und dass Diffusionsregionen (N+) im Substrat (90) angeordnet sind.

4. Festwertspeicher nach Anspruch 3, dadurch gekennzeichnet, dass selektierte Transistoren beim Herstellungsvorgang mit höherer Schwellwertspannung als die restlichen innerhalb der Matrix hergestellt werden.

5. Festwertspeicher nach den Ansprüchen 1 bis 4, dadurch gekennzeichnet, dass auf dem Substrat (90) eine Vielzahl der ersten Gruppe von Leitungen (P11–P13) und der zweiten Gruppe von Leitungen (P21 und P22) durch eine dielektrische Schicht (91) isoliert vom Substrat (90) angeordnet ist, um die Lage der entsprechenden Kontakte (54, 60, 64 und 70) zu definieren.

6. Festwertspeicher nach den Ansprüchen 1 bis 5, dadurch gekennzeichnet, dass die genannte erste Gruppe von Wortleitungen (P11 bis P13) aus Polysilicium und die genannte zweite Gruppe von Wortleitungen (P21 bis P23) aus einem Metall, vorzugsweise Aluminium bestehen.

7. Festwertspeicher nach den Ansprüchen 1 bis 5, dadurch gekennzeichnet, dass sowohl die erste als auch die zweite Gruppe der Wortleitungen (P11 bis P13; P21 bis P23) aus selbstisolierendem Material, insbesondere Polysilicium besteht.

8. Festwertspeicher nach den Ansprüchen 1 bis 6, dadurch gekennzeichnet, dass die ersten und zweiten Gruppen von Leitungen (P11 bis P13; P21 bis P23) aus gedoptem Polysilicium und die anderen genannten Leitungen (z.B. G2, G3) aus Aluminium bestehen.

9. Festwertspeicher nach den Ansprüchen 1 bis 8, dadurch gekennzeichnet, dass gebildete dicke Oxidsegmente (92) und dicke Oxidstreifen (94 und 96) eine Gate-Elektrode eines Transistors definieren und dass wenigstens ein Transistor in dieser Region eine substantiell verschiedene Schwellwertspannung im Vergleich zu den Schwellwertspannungen der restlichen Transistoren aufweist.

**Claims**

1. Read only memory in high integration technology, with memory cells arranged matrix-fashion in word and bit line intersections, said cells consisting of a field effect transistor with gate, drain and source electrodes, characterized in that a first group of word lines (P11 to P13) extends horizontally, and a second group of word lines (P21 to P23) vertically, that the bit lines (B1, B2) and lines (G1 to G4) for a reference potential are arranged diagonally to the word lines, that the word lines are connected to the gate electrodes, that the bit lines are connected with the drain electrodes and the lines for the reference potential with the source electrodes via contacts (64, 62), and that each contact (e.g. 70) of the bit lines not provided at the edge of the matrix, as well as each contact (e.g. 62) of the lines for the reference potential not provided at the edge of the matrix is connected to four cells via a diffusion region (N+) that is provided under the contact and forms four source or four drain electrodes, respectively.

2. Read only memory as claimed in claim 1, characterized in that a predetermined number of field effect transistors (36, 20) comprise different threshold voltages within one matrix-shaped arrangement.

3. Read only memory as claimed in claims 1 and 2, characterized in that the first group of word lines (P11–P13) is provided in insulation on the substrate (90), that the bit lines (B1, B2) and further lines (e.g. G2) are also insulated on the substrate (90) and that the first group of word lines are arranged intersecting each other, and that diffusion regions (N+) are arranged in the substrate (90).

4. Read only memory as claimed in claim 3, characterized in that in the manufactoring process selected transistors with a threshold voltage are made that is higher than that of the remaining transistors within the matrix.

5. Read only memory as claimed in claims 1 to 4, characterized in that in the substrate (90) a plurality of the first group of lines (P11–P13) and of the second group of lines (P21 and P22) is arranged insulated from the substrate (90) by a dielectric layer (91) in order to define the position of the corresponding contacts (54, 60, 64 and 70).

6. Read only memory as claimed in claims 1 to 5, characterized in that the first group of word lines (P11 to P13) consists of polysilicon, and the above second group of word lines (P21 to P23) of a metal, preferably aluminium.

7. Read only memory as claimed in claims 1 to 5, characterized in that the first as well as the second group of word lines (P11 to P13; P21 to P23) consists of self-insulating material, particularly polysilicon.

8. Read only memory as claimed in claims 1 to 6, characterized in that the first and second groups of lines (P11 to P13; P21 to P23) consist of doped polysilicon, and the other lines (e.g. G2, G3) of aluminum.

9. Read only memory as claimed in claims 1 to 8, characterized in that thick oxide segments (92) and thick oxide stripes (94 and 96) define a gate electrode of a transistor, and that at least one transistor in this region comprises a substantially different threshold voltage compared with the threshold voltage of the remaining transistors.

**Revendications**

1. Mémoire morte de fort degré d'intégration comportant des cellules de mémoire qui sont disposées en forme de matrice en des points de croisement de conducteurs de mots et de bits et qui se composent d'un transistor à effet de champ comportant des électrodes de grille, de drain et de source, caractérisée en ce qu'un premier groupe de conducteurs de mots (P11 à P13) est disposé horizontalement et un second groupe de conducteurs de mots (P21 à P23) est disposé verticalement, en ce que les conducteurs de bits (B1, B2) et les conducteurs (G1 à G4) d'un potentiel de référence sont disposés en oblique par rapport aux conducteurs de mots, en ce que les conducteurs de mots sont reliés aux électrodes de grille, en ce que les conducteurs de bits sont reliés aux électrodes de drain et les conducteurs de potentiel de référence aux électrodes de source par l'intermédiaire de contacts (64, 62) et en ce que chaque contact (par ex. 70) des conducteurs de bits qui n'est pas placé sur le bord de la matrice ainsi que chaque contact (par ex. 62) des conducteurs de potentiel de référence qui n'est pas placé sur le bord de la matrice sont reliés avec quatre cellules par l'intermédiaire d'une région de diffusion (N+) disposée en dessous du contact et formant quatre électrodes de source ou quatre électrodes de drain.

2. Mémoire morte selon la revendication 1, caractérisée en ce qu'un nombre prédéterminé de transistors à effet de champ (36, 20) comportent des tensions de seuil qui sont différentes à l'intérieur d'un agencement en forme de matrice.

3. Mémoire morte selon les revendications 1 et 2, caractérisée en ce que le premier groupe de conducteurs de mots (P11–P13) est disposé de façon isolée sur le substrat (90), en ce que les conducteurs de bits (B1, B2) et d'autres conducteurs (par ex. G2) sont disposés également de façon isolée sur le substrat (90) et croisent le premier groupe de conducteurs de mots, et en ce que des régions de diffusion (N+) sont disposées dans le substrat (90).

4. Mémoire morte selon la revendication 3, caractérisée en ce que les transistors sélectionnés sont réalisés, lors du processus de fabrication, avec une plus grande tension de seuil que les autres à l'intérieur de la matrice.

5. Mémoire morte selon les revendications 1 à 4, caractérisée en ce que sur le substrat (90) un grand nombre des conducteurs (P11–P13) du premier groupe et des conducteurs (P21 et P22) du second groupe sont disposés en étant isolés du substrat (90) par une couche diélectrique (91) pour définir les positions des contacts correspondants (54, 60, 64 et 70).

6. Mémoire morte selon les revendications 1 à 5, caractérisée en ce que les conducteurs de mots (P11 à P13) du groupe cité en premier sont constitués de polysilicium et les conducteurs de mots (P21 à P23) du groupe cité en second sont constitués d'un métal, de préférence d'aluminium.

7. Mémoire morte selon les revendications 1 à 5, caractérisée en ce qu'aussi bien le premier groupe que le second groupe de conducteurs de mots (P11 à P13; P21 à P23) se composent d'une matière auto-isolante, notamment du polysilicium.

8. Mémoire morte selon les revendications 1 à 6, caractérisée en ce que le premier et le second groupe de conducteurs (P11 à P13; P21 à P23) sont constitués de polysilicium dopé et les autres conducteurs cités (par ex. G2, G3) sont constitués d'aluminium.

9. Mémoire morte selon les revendications 1 à 8, caractérisée en ce que des segments épais d'oxyde (92) et des bandes épaisses d'oxyde (94 et 96) formés définissent une électrode de grille d'un transistor et en ce qu'au moins un transistor situé dans cette région présente une tension de seuil sensiblement différente des tensions de seuil des transistors restants.

0 025 130

FIG. 1

FIG. 2

7

FIG. 3

FIG. 6

FIG. 4

FIG. 5